# FASCICULE DE BREVET EUROPEEN

(11) **EP 2 412 097 B1**
(45) Date de publication et mention de la délivrance du brevet: **23.01.2013**
(21) Numéro de dépôt: 10709850.1
(22) Date de dépôt: 24.03.2010
(51) Int. Cl.: H03L 7/22, H03L 7/099, H03D 7/16, H04B 1/04, H04B 1/26, H04B 1/40, H03L 7/23

(54) **SYNTHETISEUR DE FREQUENCE**
FREQUENZSYNTHESIZER
FREQUENCY SYNTHESIZER

(30) Priorité: 24.03.2009 EP 09156065
(43) Date de publication de la demande: 01.02.2012
(73) Titulaire: CSEM Centre Suisse d'Electronique et de Microtechnique SA - Recherche et Développement, 2002 Neuchâtel (CH)
(72) Inventeur: RUFFIEUX, David, CH-1789 Lugnorre (CH)
(74) Mandataire: GLN
(86) Numéro de dépôt international: PCT/EP2010/053817
(87) Numéro de publication internationale: WO 2010/108943

(56) Documents cités:
- WO-A2-2008/036389
- FR-A1- 2 864 733
- US-A- 5 038 404
- US-A1- 2004 092 234
- US-A1- 2006 001 494
- US-B1- 6 566 921

## Description

### Domaine technique

La présente invention se rapporte au domaine des synthétiseurs de fréquence, et plus particulièrement aux synthétiseurs de fréquence destinés aux dispositifs à radiofréquences (RF).

### État de la technique

Les dispositifs émetteur et/ou récepteur à radiofréquences nécessitent des horloges RF (généralement de l'ordre du GHz), et ayant une grande pureté spectrale (c'est-à-dire dont la composante à la fréquence centrale du spectre a une amplitude très supérieure aux autres composantes du spectre). La fréquence de ces horloges doit également pouvoir être ajustée facilement, afin de couvrir la bande de fréquence visée. Des normes prévoient généralement l'allocation de bandes de fréquences, et ces bandes de fréquences peuvent être divisées en une pluralité de canaux consécutifs. Il faut donc être capable de produire une horloge dont la fréquence peut couvrir chaque canal de la bande de fréquence.

Généralement, les synthétiseurs de fréquence destinés à générer ces horloges RF sont basés sur l'utilisation d'une horloge de référence, de fréquence très inférieure à la fréquence de l'horloge RF à obtenir. Une PLL (de l'anglais Phase-Locked Loop, pour boucle à verrouillage de phase) est ensuite utilisée afin de multiplier la fréquence de l'horloge de référence pour atteindre la fréquence voulue. L'utilisation, dans la boucle de la PLL, d'un diviseur de fréquence fractionnaire permet d'obtenir une horloge RF dont la fréquence est un multiple non-entier de la fréquence de l'horloge de référence, permettant ainsi un ajustement très fin de la fréquence de l'horloge RF. L'horloge RF peut-être obtenue au moyen d'un circuit résonant LC, et dont la capacité serait variable afin d'augmenter la plage de fréquences atteignables. La pureté spectrale de l'horloge obtenue avec un tel synthétiseur peut toutefois s'avérer insuffisante, particulièrement si l'inductance du circuit LC est réalisée sur circuit intégré ou alors nécessiter une consommation très importante, ce qui pénalise l'autonomie du système utilisant ce type de synthétiseur.

Des oscillateurs basés sur un élément résonant électromécanique à haute fréquence tel qu'un BAW (Bulk Acoustic Wave) permettent d'obtenir une pureté spectrale fortement améliorée par rapport à l'oscillateur LC (de l'ordre de 30 dB de gain à puissance égale). Un élément capacitif variable permet de modifier la fréquence de l'horloge produite par un tel oscillateur, mais la plage de variation de cette fréquence n'est pas aussi étendue que celle d'un oscillateur LC avec une capacité variable, et ne permet généralement pas de couvrir une bande de fréquence de largeur suffisante. Ainsi, de tels oscillateurs sont utilisés de préférence pour générer des signaux d'horloge à une fréquence RF fixe, le vieillissement et la dépendance de la fréquence à la température pouvant être compensés par l'utilisation d'une référence plus stable, telle qu'un quartz.

Afin d'améliorer l'étendue de la plage de variation de la fréquence de l'horloge produite par un BAW, il est possible de diviser la fréquence obtenue par l'oscillateur BAW, par une division fractionnaire, afin d'obtenir un signal IF (Intermediate Frequency), dont la fréquence est variable par modification du facteur de division. Cette horloge IF est ensuite mélangée à l'horloge RF issue de l'oscillateur BAW afin d'obtenir une horloge RF de fréquence variable. Cette solution n'est pas satisfaisante, car la division fractionnaire introduit un bruit de phase important sur l'horloge IF. Il en résulte, après mélange, que le bruit de phase sur l'horloge RF de fréquence variable est du même ordre de grandeur ou même supérieur à celui atteignable avec un oscillateur LC. L'avantage de la pureté spectrale de l'oscillateur BAW est ainsi perdu.

Par ailleurs, le document US6566921 divulgue un synthétiseur de fréquence comprenant un premier oscillateur commandé par un premier dispositif d'asservissement, asservissant la fréquence du premier oscillateur à partir d'une première fréquence de référence. Le synthétiseur comprend encore un second oscillateur commandé par un second dispositif d'asservissement et produisant un second signal d'horloge. Le second dispositif d'asservissement est commandé à partir d'une seconde fréquence de référence. On a encore un diviseur entier de fréquence qui divise la fréquence du second signal d'horloge et un diviseur de fréquence dont l'entrée est le premier signal d'horloge pour produire la seconde fréquence de référence. La pureté spectrale du signal de sortie fourni par un tel synthétiseur n'est cependant pas optimale et la fréquence de ce signal de sortie ne peut être sélectionnée qu'avec une résolution limitée.

La présente invention propose un synthétiseur de fréquence permettant d'obtenir un signal d'horloge de fréquence variable et à haute pureté spectrale tout en évitant les inconvénients ci-dessus.

### Divulgation de l'invention

La présente invention concerne un synthétiseur de fréquence tel que décrit dans les revendications de la présente demande.

### Brève description des dessins

D'autres caractéristiques de la présente invention apparaîtront plus clairement à la lecture de la description qui va suivre, faite en référence au dessin annexé, dans lequel :
- la figure 1 représente un synthétiseur de fréquence,
- la figure 2 représente un synthétiseur de fréquence selon une première variante de la présente invention,
- la figure 3 représente un synthétiseur de fréquence selon une deuxième variante de la présente invention,
- la figure 4 représente un dispositif à radiofréquences utilisant un synthétiseur de fréquence selon la figure 1.

### Modes de réalisation de l'invention

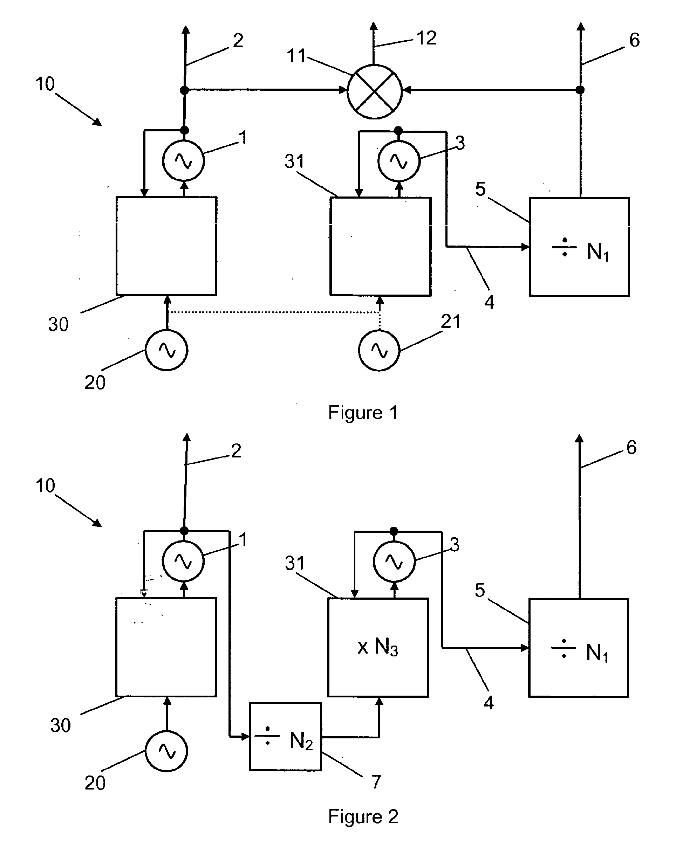

Une première variante d'un synthétiseur de fréquence est présentée en figure 2, le synthétiseur de fréquence 10 comprenant :
- un premier oscillateur commandé 1 par un premier dispositif d'asservissement, le premier oscillateur commandé présentant un facteur de qualité élevé, typiquement supérieur à 300 et produisant un premier signal d'horloge 2 RF de fréquence fixe,
- le premier dispositif d'asservissement 30 asservissant la fréquence du premier oscillateur commandé 1 à partir d'une première fréquence de référence,
- un second oscillateur commandé 3 par un second dispositif d'asservissement, et produisant un second signal d'horloge 4,
- le second dispositif d'asservissement 31 asservissant la fréquence du second oscillateur commandé 3 à partir d'une seconde fréquence de référence, et
- un diviseur entier de fréquence 5, divisant la fréquence du second signal d'horloge 4 par un facteur entier N₁ variable, et produisant un troisième signal d'horloge 6 dont la fréquence est variable de façon continue par modification du facteur N₁ et de la commande du seconde oscillateur.
- un diviseur fractionnaire de fréquence 7, dont l'entrée est le premier signal d'horloge 2 et divisant sa fréquence par un facteur fractionnaire N₂ variable, produisant la seconde fréquence de référence, le second dispositif d'asservissement 31 multipliant la fréquence de la seconde fréquence de référence par un facteur N₃, pour produire le second signal d'horloge 4.

La pureté spectrale d'un oscillateur est liée au facteur de qualité Q du résonateur utilisé. Plus le facteur Q est élevé, plus la pureté spectrale du signal d'horloge produit par l'oscillateur est grande. Le facteur de qualité Q est défini par le rapport entre l'énergie stockée dans le résonateur et celle qui y est dissipée par cycle.

L'ensemble constitué du premier oscillateur commandé et du premier dispositif d'asservissement 30 est classiquement une PLL, dont l'entrée est une première fréquence de référence produite par un troisième oscillateur fixe 20.

Pour obtenir un facteur de qualité supérieur à 300, le premier oscillateur commandé 1 est basé sur un élément résonant électromécanique à haute fréquence tel qu'un BAW (Bulk Acoustic Wave). Un oscillateur de type SAW (Surface Acoustic Wave) est également adapté.

L'utilisation d'un diviseur de fréquence 5 ayant un facteur de division N₁ entier permet de réduire de manière importante le bruit de phase du troisième signal d'horloge 6, le bruit de phase étant réduit d'un rapport qui est le carré du facteur de division. Par exemple, une division avec un facteur de N₁=30 permet de diminuer le bruit de phase de 30 dB. De plus, avec un facteur N₁ variable, on étend la plage de réglage de fréquence du troisième signal d'horloge 6 malgré une plage de variation limitée du second signal d'horloge 4.

La fréquence de l'oscillateur 3 et le facteur de division du diviseur entier de fréquence 5 sont déterminées de telle sorte que le bruit de phase du troisième signal d'horloge 6 soit équivalent à celui du premier oscillateur 1.

Les puretés spectrales des signaux d'horloge 2 et 6 sont alors du même ordre de grandeur et ces signaux d'horloge peuvent ensuite avantageusement être mélangés par un premier mélangeur 11, de telle sorte que la dégradation, due aux bruits respectifs des signaux mélangés, soit réduite, typiquement à 3 dB environ. Ainsi, le premier mélangeur 11 d'un tel synthétiseur permet de produire un quatrième signal RF qui peut être utilisé comme porteuse RF et dont la pureté spectrale est très élevée. La fréquence de la porteuse est variable en continu en fonction de la plage de réglage de fréquence du troisième signal d'horloge 6 qui dépend de la combinaison de la plage de réglage de l'oscillateur 3 et du facteur N1.

Les autres éléments, hors mélangeur 11, sont les mêmes que ceux représentés sur la figure 1 et portent les mêmes références.

Cette variante présente les mêmes avantages que la première variante. En outre, le premier oscillateur commandé 1 est utilisé d'une part pour générer le premier signal d'horloge 2, mais également pour produire via le diviseur fractionnaire 7, la seconde fréquence de référence destinée à asservir la fréquence du second oscillateur commandé 3 à l'aide du second dispositif d'asservissement 31. Le rôle de ce dispositif d'asservissement 31 est de supprimer le bruit de phase introduit par le diviseur fractionnaire 7, à large écart de fréquence de la porteuse, et de permettre de produire, à l'aide du diviseur fractionnaire 5, un rapport de fréquence de (1/N₂)*(N₃/N₁) entre le premier signal d'horloge 2 et le troisième signal d'horloge 6. En minimisant les valeurs de N₂ et N₃, on obtient la meilleure performance de bruit, ce qui permet d'augmenter la bande passante de l'ensemble constitué de l'oscillateur commandé 3 et du dispositif d'asservissement 31. De plus, en changeant dynamiquement la valeur de N₂, une modulation de phase peut être effectuée sur le troisième signal d'horloge 6, à condition que la fréquence de modulation reste dans la bande passante du second dispositif d'asservissement 31. Selon cette variante, la première fréquence de référence peut avantageusement être obtenue au moyen d'un quartz de fréquence faible, par exemple 32 kHz, ce qui est particulièrement intéressant du point de vue de la consommation lorsque le synthétiseur de fréquence fonctionne en mode intermittent et du point de vue du nombre de composants externes requis qui se limite à ce même quartz.

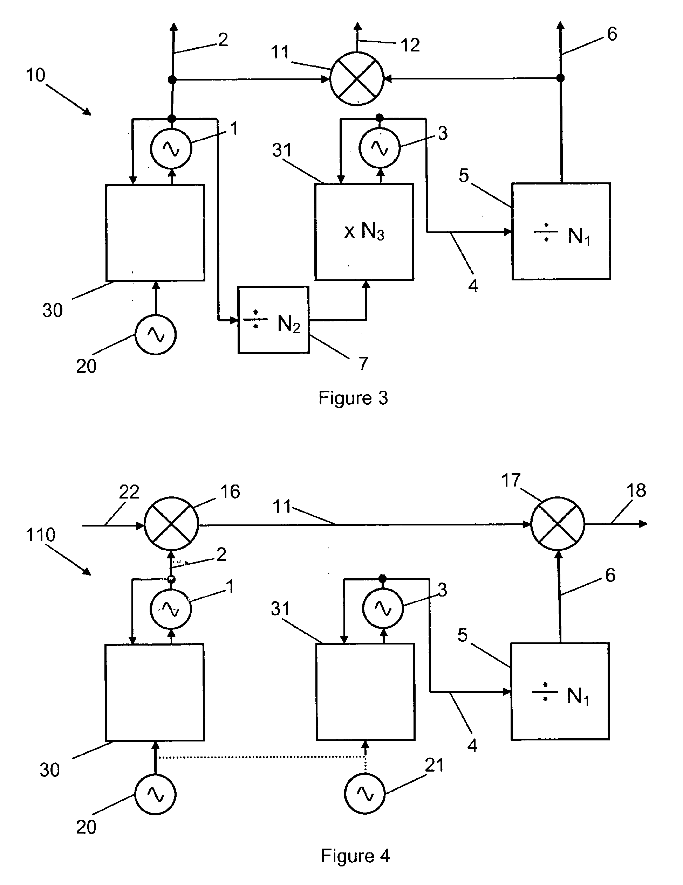

Dans une troisième variante présentée en référence à la figure 3, le synthétiseur de fréquence 10 comprend, outre les éléments de la première variante, le diviseur fractionnaire 7 de la seconde variante.

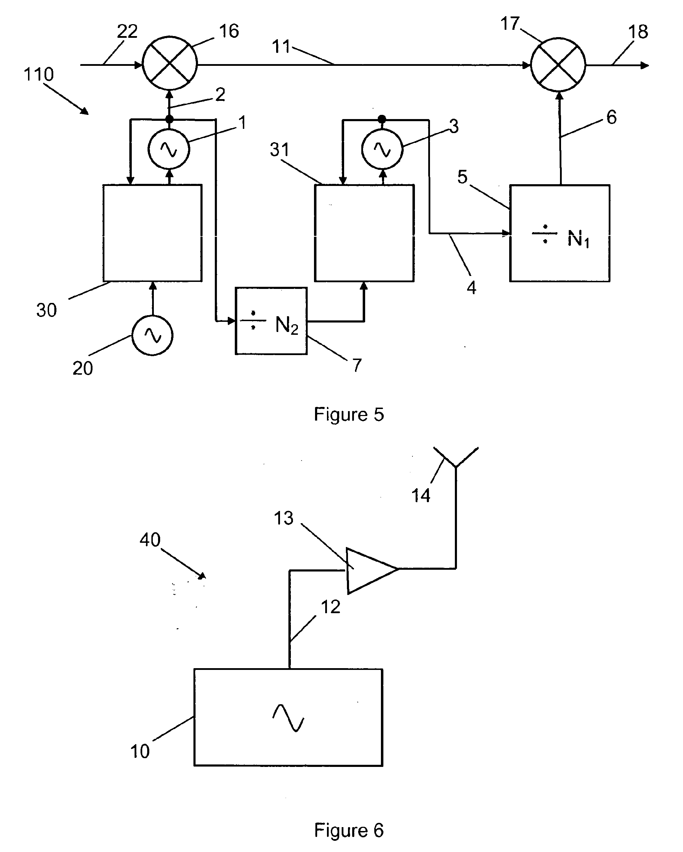

Une quatrième variante destinée à être utilisée comme synthétiseur 110 de chaîne de réception, est présentée en référence à la figure 5. A l'exception du premier mélangeur 11, cette troisième variante reprend les éléments de la première variante, portant les mêmes références sur la figure. Elle comprend en outre un deuxième 16 et un troisième 17 mélangeurs. Le deuxième mélangeur 16 est configuré pour mélanger un signal d'entrée RF modulé 22 avec le premier signal d'horloge 2. Le troisième mélangeur 17 est configuré pour mélanger le signal de sortie du deuxième mélangeur 16 avec le troisième signal d'horloge 6 de sorte qu'un signal de sortie à faible fréquence est produit, correspondant à la transposition en bande de base ou à faible fréquence intermédiaire (low-IF) du signal d'entrée RF 22.

Les synthétiseurs de fréquence selon les diverses variantes présentées ci-dessus peuvent être avantageusement employés dans des dispositifs à radiofréquences.

Ainsi, en relation avec la figure 6, le synthétiseur de fréquence 10 selon la deuxième variante, est utilisé dans un dispositif à radiofréquences formant un émetteur RF 40. Le quatrième signal RF 12 de fréquence variable produit par le premier mélangeur 11 (non visible sur la figure) est utilisé comme porteuse RF 12. Pour la deuxième variante de synthétiseur, la modulation de fréquence est obtenue grâce au facteur N₂. En faisant varier ce facteur, il est possible d'introduire les données à transmettre et d'obtenir très facilement une porteuse RF 12 modulée en fréquence avec une grande pureté spectrale. Le dispositif comprend en outre un amplificateur RF 13, dont l'entrée est connectée à la porteuse RF 12 et une antenne 14, émettant le signal de sortie de l'amplificateur RF 13.

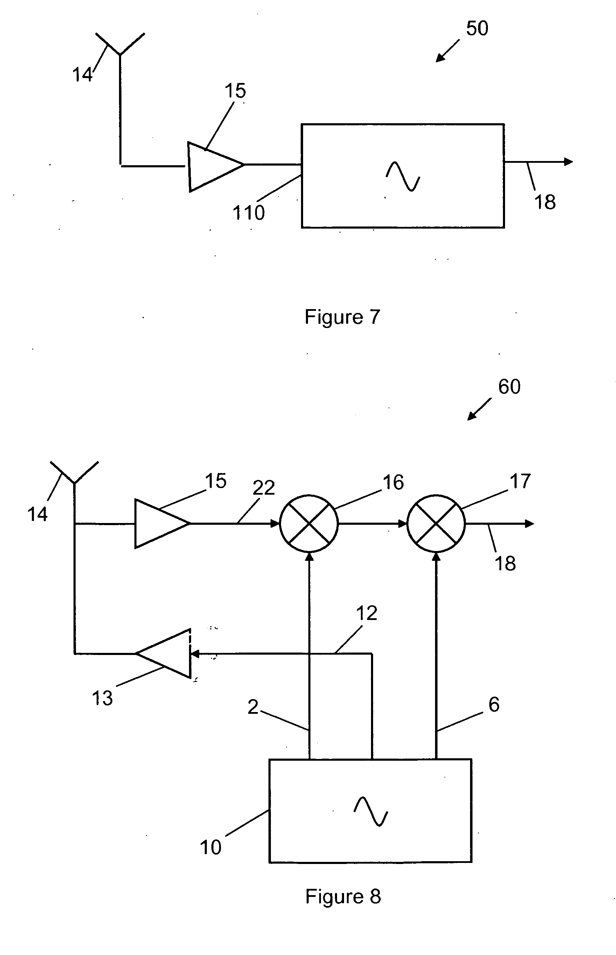

En relation avec la figure 7, un dispositif à radiofréquence complémentaire du dispositif précédent est également obtenu. Le synthétiseur de fréquence 10 selon l'invention est utilisé pour former un récepteur RF 50. A cet effet, la troisième variante du synthétiseur de fréquence 110 est employée. En outre, une antenne 14 est configurée pour recevoir un signal en réception et le fournir en entrée d'un récepteur RF 15. La sortie du récepteur RF 15 est à son tour fournie en entrée du synthétiseur de chaîne de réception 110. Celui-ci produit en sortie 18 un signal correspondant à la transposition en bande de base ou à faible fréquence intermédiaire (low-IF) du signal reçu sur l'antenne 14.

Enfin, en relation avec la figure 8, un dispositif à radiofréquence combinant l'émetteur et le récepteur RF précédemment décrits est obtenu afin de former un transmetteur 60. A cet effet, le synthétiseur de fréquence 10 selon la deuxième variante est utilisé dans la description suivante. On notera cependant que le synthétiseur de fréquence 110 selon la troisième variante permet d'obtenir le même résultat. Le synthétiseur de fréquence 10 génère donc un premier signal d'horloge 2, de type RF et de fréquence fixe, un troisième signal d'horloge 6, dont la fréquence est variable et une porteuse RF 12, produits par le premier mélangeur 11 (non visible sur la figure). Le transmetteur 60 comprend en outre:
- un amplificateur RF 13, dont l'entrée est connectée à la porteuse RF 12,
- une antenne 14, émettant le signal de sortie de l'amplificateur RF 13, et recevant un signal en réception,
- un récepteur RF 15, dont l'entrée est connectée à l'antenne 14,
- un second mélangeur 16, mélangeant le signal de sortie du récepteur 15 et le premier signal d'horloge 2, et
- un troisième mélangeur 17, mélangeant le signal de sortie du second mélangeur 16 et le troisième signal d'horloge 6, produisant un signal correspondant à la transposition en bande de base ou à faible fréquence intermédiaire (low-IF) du signal reçu sur l'antenne 14.

La modulation de fréquence introduite grâce au facteur N₂ variable permet très facilement d'obtenir une porteuse RF 12 modulée en fréquence et ayant une grande pureté spectrale de façon à introduire les données à transmettre.

Un diviseur fixe de fréquence divisant la fréquence par 2 peut également être intercalé entre d'une part le troisième signal d'horloge 6 et d'autre part les premier 11 et troisième 17 mélangeurs, afin de générer des signaux en quadrature. Cette configuration permet d'implémenter, pour les mélangeurs 11, 16 et 17, des mélangeurs à réjection d'image.

Bien entendu, la présente invention est susceptible de diverses variantes et modifications qui apparaîtront évidentes à l'homme du métier.

## Revendications

1. Synthétiseur de fréquence (10) comprenant :
- un premier oscillateur commandé (1) par un premier dispositif d'asservissement, le premier oscillateur (1) présentant un facteur de qualité élevé, supérieur à 300 et produisant un premier signal d'horloge (2) RF de fréquence fixe,
- le premier dispositif d'asservissement (30), asservissant la fréquence du premier oscillateur commandé (1) à partir d'une première fréquence de référence,
- un second oscillateur commandé (3) par un second dispositif d'asservissement, et produisant un second signal d'horloge (4),
- le second dispositif d'asservissement (31), asservissant la fréquence du second oscillateur commandé (3) à partir d'une seconde fréquence de référence, et
- un diviseur entier de fréquence (5), divisant la fréquence du second signal d'horloge (4) par un facteur entier N₁ variable, et produisant un troisième signal d'horloge (6) dont la fréquence est variable de façon continue par modification du facteur N₁ et de la commande du second oscillateur,
- un diviseur fractionnaire de fréquence (7), dont l'entrée est le premier signal d'horloge (2) et divisant sa fréquence par un facteur fractionnaire N₂ variable, produisant la seconde fréquence de référence, le second dispositif d'asservissement (31) multipliant la fréquence de la seconde fréquence de référence par un facteur N₃, pour produire le second signal d'horloge (4).

2. Synthétiseur de fréquence de chaîne de réception (110) comprenant le synthétiseur de la revendication 1 et comprenant en outre :
- un second mélangeur (16), configuré pour mélanger un signal d'entrée RF modulé et le premier signal d'horloge (2), et
- un troisième mélangeur (17), configuré pour mélanger le signal de sortie du second mélangeur (16) et le troisième signal d'horloge (6), pour produire un signal en sortie à faible fréquence.

3. Synthétiseur de fréquence (10, 110) selon l'une quelconque des revendications 1 et 2, **caractérisé en ce que** la première fréquence de référence est produite par un troisième oscillateur fixe (20).

4. Synthétiseur de fréquence (10, 110) selon l'une quelconque des revendications précédentes, **caractérisé en ce que** le premier oscillateur commandé (1) comprend un résonateur de type BAW ou SAW.

5. Synthétiseur de fréquence (10, 110) selon l'une quelconque des revendications précédentes, **caractérisé en ce que** le second oscillateur commandé (3) est un oscillateur LC.

6. Dispositif à radiofréquence (50) comprenant :
- une antenne (14), configurée pour recevoir un signal en réception,
- un récepteur RF (15), dont l'entrée est connectée à l'antenne (14),
- le synthétiseur de fréquence de chaîne de réception (110) selon la revendication 2, configuré pour recevoir en entrée la sortie du récepteur RF (15) et pour produire en sortie un signal correspondant à la transposition en bande de base ou à faible fréquence intermédiaire (low-IF) du signal reçu sur l'antenne (14).

7. Dispositif à radiofréquences (60) comprenant :
- le synthétiseur de fréquence (10, 110) selon l'une des revendications 2, 3, dont le quatrième signal RF (12) est utilisé comme porteuse RF,
- un amplificateur RF (13), dont l'entrée est connectée au quatrième signal RF (12),
- une antenne (14), configurée pour émettre le signal de sortie de l'amplificateur RF (13), et pour recevoir un signal en réception,
- un récepteur RF (15), dont l'entrée est connectée à l'antenne (14),
- un second mélangeur (16), configuré pour mélanger le signal de sortie du récepteur (15) et le premier signal d'horloge (2), et
- un troisième mélangeur (17), configuré pour mélanger le signal de sortie du second mélangeur (16) et le troisième signal d'horloge (6), pour produire un signal correspondant à la transposition en bande de base ou à faible fréquence intermédiaire (low-IF) du signal reçu sur l'antenne (14).

8. Dispositif à radiofréquences (60) selon la revendication 7, **caractérisé en ce qu'**il comprend en outre un diviseur fixe de fréquence, destiné à diviser la fréquence par 2, intercalé entre d'une part le troisième signal d'horloge (6) et d'autre part les premier (11) et troisième (17) mélangeurs.

9. Dispositif à radiofréquences (40, 50, 60) selon l'une quelconque des revendications 6 à 8, **caractérisé en ce que** les mélangeurs sont des mélangeurs à réjection d'image.

## Claims

1. Frequency synthesizer (10) comprising:
- a first oscillator (1) controlled by a first control device, the first controlled oscillator (1) having a high quality factor, typically greater than 300 and producing a first clock signal (2) RF having a fixed frequency,
- the first control device (30) controlling the frequency of the first controlled oscillator (1) on the basis of a first reference frequency,
- a second oscillator (3) controlled by a second control device, and producing a second clock signal (4),
- the second control device (31) controlling the frequency of the second controlled oscillator (3) on the basis of a second reference frequency, and
- an integer frequency divider (5), dividing the frequency of the second clock signal (4) by a variable integer factor N1 and producing a third clock signal (6), the frequency of which is continuously variable by modifying the factor N1 and the control of the second oscillator,
- a fractional frequency divider (7), the input of which is the first clock signal (2) and dividing its frequency by a variable fractional factor N2, producing the second reference frequency, the second control device (31) multiplying the frequency of the second reference frequency by a factor N3, to produce the second clock signal (4).

2. Receiving channel frequency synthesizer (110) comprising the synthesizer of claim 1 and comprising furthermore:
- a second mixer (16), configured to mix a modulated RF input signal and the first clock signal (2), and
- a third mixer (17), configured to mix the output signal of the second mixer (16) and the third clock signal (6), to produce a low-frequency output signal.

3. Frequency synthesizer (10, 110) according to any one of claims 1 and 2, **characterized in that** the first reference frequency is produced by a third fixed oscillator (20).

4. Frequency synthesizer (10, 110) according to any one of the preceding claims, **characterized in that** the first controlled oscillator (1) comprises a resonator of the BAW or SAW type.

5. Frequency synthesizer (10, 110) according to any one of the preceding claims, **characterized in that** the second controlled oscillator (3) is an LC oscillator.

6. Radiofrequency device (50) comprising:
- an antenna (14), configured to receive a reception signal,
- an RF receiver (15), the input of which is connected to the antenna (14),
- the receiving channel frequency synthesizer (110) according to claim 2, configured to receive, as input, the output of the RF receiver (15) and to produce, as output, a signal corresponding to the baseband or low-IF transposition of the received signal no the antenna (14).

7. Radiofrequency device (60) comprising:
- the frequency synthesizer (10, 110) according to claim 2, the fourth RF signal (12) of which is used as RF carrier,
- an RF amplifier (13), the input of which is connected to the fourth RF signal (12),
- an antenna (14), configured to transmit the output signal of the RF amplifier (13), and to receive a reception signal,
- an RF receiver (15), the input of which is connected to the antenna (14),
- a second mixer (16), configured to mix the output signal of the receiver (15) and the first clock signal (2), and
- a third mixer (17), configured to mix the output signal of the second mixer (16) and the third clock signal (6), to produce a signal corresponding to the baseband or low-IF transposition of the received signal on the antenna (14).

8. Radiofrequency device (60) according to claim 7, **characterized in that** it also comprises a fixed frequency divider, intended to divide the frequency by 2, inserted between the third clock signal (6) on the one hand and the first (11) and third (17) mixers on the other hand.

9. Radiofrequency device (40, 50, 60) according to any one of claims 11 to 14, **characterized in that** the mixers are image-rejection mixers.

## Patentansprüche

1. Frequenzsynthetisator (10), der umfasst :
- einen ersten Oszillator (1), der von einer ersten Regelungsvorrichtung gesteuert wird, wobei der erste Oszillator (1) einen erhöhten Qualitätsfaktor über 300 aufweist und ein erstes Funkfrequenz-Uhrensignal (2) mit Festfrequenz erzeugt,
- wobei die erste Regelungsvorrichtung (30) die Frequenz des ersten gesteuerten Oszillators (1) ausgehend von einer ersten Referenzfrequenz regelt,
- einen zweiten Oszillator (3), der von einer zweiten Regelungsvorrichtung gesteuert wird und ein zweites Uhrensignal (4) erzeugt,
- wobei die zweite Regelungsvorrichtung (31) die Frequenz des zweiten gesteuerten Oszillators (3) ausgehend von einer zweiten Referenzfrequenz regelt, und
- einen ganzen Frequenzteiler (5), der die Frequenz des zweiten Uhrensignals (4) durch einen variablen ganzen Faktor N₁ teilt und ein drittes Uhrensignal (6) erzeugt, dessen Frequenz durch Änderung des Faktors N₁ und der Steuerung des zweiten Oszillators kontinuierlich variabel ist,
- einen Frequenzteiler (7) mit gebrochenem Teilungsverhältnis, dessen Eingang das erste Uhrensignal (2) ist und wobei seine Frequenz durch einen variablen Faktor N₂ mit gebrochenem Teilungsverhältnis geteilt wird, wodurch die zweite Referenzfrequenz erzeugt wird, wobei die zweite Regelungsvorrichtung (31) die Frequenz der zweiten Referenzfrequenz mit einem Faktor N₃ multipliziert, um das zweite Uhrensignal (4) zu erzeugen.

2. Empfangsketten-Frequenzsynthetisator (110), der den Synthetisator von Anspruch 1 umfasst und ferner umfasst:
- einen zweiten Mischer (16), der konfiguriert ist, um ein moduliertes Funkfrequenz-Eingangssignal und das erste Uhrensignal (2) zu mischen, und
- einen dritten Mischer (17), der konfiguriert ist, um das Ausgangssignal des zweiten Mischers (16) und das dritte Uhrensignal (6) zu mischen, um ein schwachfrequentes Ausgangssignal zu erzeugen.

3. Frequenzsynthetisator (10, 110) nach einem der Ansprüche 1 und 2, **dadurch gekennzeichnet, dass** die erste Referenzfrequenz von einem festen dritten Oszillator (20) erzeugt wird.

4. Frequenzsynthetisator (10, 110) nach einem der vorangehenden Ansprüche, **dadurch gekennzeichnet, dass** der erste gesteuerte Oszillator (1) einen Resonator vom Typ BAW oder SAW umfasst.

5. Frequenzsynthetisator (10, 110) nach einem der vorangehenden Ansprüche, **dadurch gekennzeichnet, dass** der zweite gesteuerte Oszillator (3) ein LC-Oszillator ist.

6. Funkfrequenzvorrichtung (50), die aufweist:
- eine Antenne (14), die konfiguriert ist, um ein Empfangssignal zu empfangen,
- einen Funkfrequenz-Empfänger (15), dessen Eingang mit der Antenne (14) verbunden ist,
- den Empfangsketten-Frequenzsynthetisator (110) nach Anspruch 2, der konfiguriert ist, um am Eingang den Ausgang des Funkfrequenz-Empfängers (15) zu empfangen und um am Ausgang ein Signal zu erzeugen, das der Transposition des über die Antenne (14) empfangenen Signals in Basisband oder mit schwacher Zwischenfrequenz (low-IF) entspricht.

7. Funkfrequenzvorrichung (60), die aufweist:
- den Frequenzsynthetisator (10, 110) nach einem der Ansprüche 2, 3, dessen viertes Funkfrequenz-Signal (12) als Träger-Funkfrequenz verwendet wird,
- einen Funkfrequenz-Verstärker (13), dessen Eingang mit dem vierten Funkfrequenz-Signal (12) verbunden ist,
- eine Antenne (14), die konfiguriert ist, um das Ausgangsignal des Funkfrequenz-Verstärkers (13) zu senden und um ein Empfangssignal zu empfangen,
- einen Funkfrequenz-Empfänger (15), dessen Eingang mit der Antenne (14) verbunden ist,
- einen zweiten Mischer (16), der konfiguriert ist, um das Ausgangssignal des Empfängers (15) und das erste Uhrensignal (2) zu mischen, und
- einen dritten Mischer (17), der konfiguriert ist, um das Ausgangssignal des zweiten Mischers (16) und das dritte Uhrensignal (6) zu mischen, um ein Signal zu erzeugen, das der Transposition des über die Antenne (14) empfangenen Signals in Basisband oder mit schwacher Zwischenfrequenz (low-IF) entspricht.

8. Funkfrequenzvorrichtung (60) nach Anspruch 7, **dadurch gekennzeichnet, dass** sie ferner einen festen Frequenzteiler umfasst, der dazu bestimmt ist, die Frequenz durch 2 zu teilen, der zwischen einerseits dem dritten Uhrensignal (6) und andererseits dem ersten (11) und dritten (17) Mischer eingefügt ist.

9. Funkfrequenzvorrichtung (40, 50, 60) nach einem der Ansprüche 6 bis 8, **dadurch gekennzeichnet, dass** die Mischer Spiegelselektionsmischer sind.
